# DEMANDE DE BREVET EUROPEEN

(11) **EP 3 435 423 A1**
(43) Date de publication de la demande: **30.01.2019**
(21) Numéro de dépôt: 18186083.4
(22) Date de dépôt: 27.07.2018
(51) Int. Cl.: H01L 31/02, H01L 31/078

(54) **CELLULE PHOTOVOLTAÏQUE TANDEM**

(30) Priorité: 28.07.2017 FR 1757234
(71) Demandeur: Centre National de la Recherche Scientifique, 75016 Paris (FR); Institut Photovoltaique D'Ile de France (IPVF), 92160 Antony (FR); Total SA, 92400 Courbevoie (FR); Electricité de France, 75008 Paris (FR); Riber, 95870 Bezons (FR)
(72) Inventeur: LINCOT, Daniel, 92160 ANTONY (FR)
(74) Mandataire: Lavoix

(57) **Abrégé**

La présente invention concerne un matériau multi-couches (1) comprenant :
(i) un assemblage de couches, dites « couches avant » (100), apte à former une cellule photovoltaïque avant et
(ii) un assemblage de couches, dites « couches arrière » (400), apte à former une cellule photovoltaïque arrière,
dans lequel l'assemblage de couches avant (100) et l'assemblage de couches arrière (400) sont isolés électriquement par une couche isolante (30) de matériau épitaxié.

## Description

La présente invention concerne le domaine des cellules photovoltaïques.

En particulier, la présente invention concerne des cellules photovoltaïques comprenant un empilement vertical de deux cellules photovoltaïques, appelées aussi cellules photovoltaïques tandem.

### Etat de la technique

Les cellules solaires à double jonction (tandem) sont considérées comme la prochaine étape dans le développement industriel du photovoltaïque, en s'appuyant sur la technologie actuellement la plus développée basée sur des cellules au silicium cristallin. La cellule silicium deviendrait alors la cellule arrière de la cellule tandem, captant le domaine infrarouge du spectre solaire, tandis qu'une autre cellule, dite cellule avant, captant les domaines complémentaire du visible et de l'UV, serait placée au-dessus. Plusieurs types d'architectures font partie de l'état de l'art, et sont illustrées dans le cas des cellules où la cellule avant est de type III-V.

Le premier type d'architecture considéré est celui dit du report mécanique de la cellule III-V sur la cellule silicium, avec déjà les contacts posés sur chacune des cellules. Si les contacts intermédiaires communiquent, les contacts résultants pour la cellule tandem sont les deux contacts avant et arrière, dans une configuration appelée à deux fils. Si les deux cellules sont isolées électriquement, on doit alors utiliser les quatre contacts, ce qui est appelé configuration quatre fils. Une autre architecture est celle où le report des deux cellules se fait directement entre les couches externes des cellules avec un contact intime au niveau atomique qui permet de faire passer le courant sans contacts rapportés comme dans le premier cas. Une troisième configuration n'utilise pas la technique de report mécanique, mais une croissance directe d'une jonction III-V sur une jonction silicium sous forme épitaxiée, ou non pour d'autres types de cellules avant. Sur le plan électrique les deux cellules sont en contact électrique directement à l'interface de croissance. Il s'agit donc d'une configuration électrique à deux fils. On retrouve un état de l'art similaire pour les autres types de cellule avant considérées, avec majoritairement des structures à 2 fils et des cellules à quatre fils rapportées mécaniquement.

Les solutions proposées actuellement sont également de fabriquer des monocellules avant, en particulier III-V, couvrant l'ensemble de la cellule silicium. Electriquement la configuration correspond à celle connue sous le terme de connexion 2 fils, où les deux jonctions sont mises en série et liées entre elles par une structure tunnel. Dans cette configuration, la cellule silicium est nécessairement une cellule ou les zones n et p sont situées de part et d'autre de la plaquette de silicium, ce qui exclut a priori l'utilisation de cellules à contacts arrière interdigités, qui sont pourtant les plus performantes au niveau des rendements.

La demande de brevet WO 2017/093695 décrit une cellule photovoltaïque à 3 contacts. De telles cellules permettent de faire transiter par exemple des électrons (porteurs de type n) de la première couche vers la deuxième couche, de les collecter depuis l'ensemble des première et deuxième couches par les premières électrodes, de collecter les trous (porteurs de type p) depuis la première couche par les deuxièmes électrodes et de collecter les électrons depuis la deuxième couche par les troisièmes électrodes. Cette architecture n'est pas entièrement monocristalline puisqu'il est conseillé d'utiliser une jonction amorphe de silicium hydrogéné, d'oxyde de silicium ou d'un alliage de carbure de silicium amorphe. Par ailleurs cette demande WO 2017/093695 préconise une autre technique de fabrication que l'épitaxie. Cette cellule photovoltaïque à 3 contacts a, comme une cellule photovoltaïque à 2 contacts, la nécessité de conduire le courant entre les deux cellules. Les deux cellules ne sont pas isolées électriquement.

Il existe également la demande de brevet WO 2009/047448 et sa famille qui concernent une méthode d'épitaxie s'affranchissant de la différence du paramètre de maille des couches de différents matériaux monocristallins. Cette demande envisage principalement des applications en microélectronique et optoélectronique comme par exemple les LED mais n'envisage pas d'application spécifique comme les cellules photovoltaïques.

Les cellules photovoltaïques tandem permettent d'envisager des rendements photovoltaïques théoriques supérieurs à 40 %. Cela peut se traduire dans la pratique par des modules de rendement supérieurs à 30 %. On peut noter que les architectures considérées pour les cellules silicium mettent en oeuvre des contacts de part et d'autre de la cellule comme c'est le cas pour les cellules classiques de type PERC, PERL....Cependant il apparait que les cellules les plus performantes actuellement sur le marché sont des cellules dites à contacts arrière interdigités, introduites sous le nom IBC (interdigitated back contacts), en particulier par la société Sunpower. Récemment une convergence a vu le jour avec les structures à hétérojonction introduites par Sanyo, avec l'introduction du concept IBC pour ces cellules qui a conduit à un rendement record de 26,6%. Ainsi les cellules silicium sont les cellules utilisées majoritairement par le marché à ce jour.

### Buts de l'invention

L'invention a pour but de résoudre le problème technique consistant à fournir une cellule photovoltaïque.

En particulier, la présente invention a pour but de résoudre le problème technique consistant à fournir une cellule photovoltaïque tandem, et en particulier utilisant une cellule photovoltaïque inférieure de silicium monocristallin.

Encore plus particulièrement, la présente invention a pour but de résoudre le problème technique consistant à fournir une cellule photovoltaïque tandem présentant un empilement vertical d'une cellule silicium et d'une cellule de type III-V, chalcogénure, en particulier des familles du séléniure de cuivre, d'indium et de gallium (noté CIGS) et du tellurure de cadmium (CdTe), ou du type pérovskite (PbNH₄I₃).

L'invention a pour but de résoudre le problème technique consistant à fournir une cellule photovoltaïque tandem avec un empilement de couches cristallines, et de préférence de couches actives principales monocristallines.

L'invention a pour but de résoudre le problème technique consistant à fournir une cellule photovoltaïque tandem avec une architecture de connectique dite monolithique de la jonction supérieure.

L'invention a aussi pour but de résoudre le problème technique consistant à fournir une cellule photovoltaïque tandem avec une cellule photovoltaïque silicium monocristallin à contacts arrière, en face avant de laquelle est empilée une cellule avec une jonction à connection monolithique, et par exemple d'une jonction de type III-V, chalcogénure (CIGS, CdTe) ou perovskite.

L'invention a encore pour but de résoudre le problème technique consistant à fournir une cellule photovoltaïque tandem à 4 fils.

L'invention a encore pour but de résoudre un ou plusieurs des problèmes techniques posés par l'invention de manière industrielle, de préférence en limitant les coûts de production.

### Description

La présente invention concerne en particulier un matériau multi-couches 1 comprenant :
(i) un assemblage de couches, dites « couches avant » 100, apte à former une cellule photovoltaïque avant et
(ii) un assemblage de couches, dites « couches arrière » 400, apte à former une cellule photovoltaïque arrière,
dans lequel l'assemblage de couches avant 100 et l'assemblage de couches arrière 400 sont isolés électriquement par une couche isolante 30 de matériau épitaxié.

Selon un mode de réalisation, l'assemblage de couches avant 100 comprend au moins une combinaison de couches formant une hétérojonction 20 comprenant un premier matériau 24 et un deuxième matériau 26, une couche 40 de contact arrière de l'hétérojonction 20, et une couche 50 de contact avant.

De préférence, l'assemblage de couches arrière 400 comprend au moins matériau monocristallin 10, typiquement du silicium monocristallin, et de préférence comprend des électrodes de contact interdigitées 40.

La présente invention concerne une cellule photovoltaïque tandem comprenant une cellule photovoltaïque silicium, à titre de jonction arrière, comprenant une couche silicium monocristallin avec en face arrière des contacts interdigités et en face avant une couche isolante épitaxiée, et, à titre de jonction avant, une hétérojonction, de préférence comprenant une ou plusieurs couches épitaxiées.

Une couche épitaxiée peut être plus ou moins homogène en composition et peut par exemple comprendre un ou plusieurs gradients de composition.

De préférence, la jonction avant est structurée en alternance (i) de zones conductrices formant les contacts avant et arrière de la jonction avant et (ii) de zones isolantes, l'alternance des zones permettant une conduction latérale entre les contacts avant et arrière de la jonction avant. On parle d'interconnexion ou connexion monolithique.

Typiquement l'alternance de zones conductrices et isolantes forme des bandes, de préférence rectilignes parallèles, de préférence motif(s) répétitif(s).

Selon un mode de réalisation, l'invention concerne un matériau multi-couches 1 comprenant :
(i) une couche d'au moins un matériau monocristallin 10 présentant une face avant 11 et une face arrière 12;
(ii) une combinaison de couches formant une hétérojonction 20 comprenant un premier matériau 24 et un deuxième matériau 26, l'hétérojonction 20 comprenant une face avant 21 et une face arrière 22;
(iii) une couche 40, comprenant une face avant 41 et une face arrière 42, dite de contact arrière de l'hétérojonction 20, la face avant 41 étant en contact avec la face arrière 22 de l'hétérojonction 20,
(iii) une couche isolante électriquement 30 présentant une face avant et une face arrière, ladite couche isolante électriquement 30 étant disposée entre la face arrière 42 de la couche arrière 40 de l'hétérojonction 20 et la face avant 11 du matériau monocristallin 10;
ladite couche isolante électriquement 30 étant en contact alternatif côté face avant 31 avec la couche de contact arrière 40 de l'hétérojonction 20 et la face arrière 22 de l'hétérojonction 20 ou d'un matériau isolant 90.

Ainsi, avantageusement, le matériau multi-couches 1 comprend dans assemblage de couches arrière 400 : la couche d'au moins un matériau monocristallin 10, et dans l'assemblage de couches avant 100 : la combinaison de couches formant une hétérojonction 20 et la couche 40 de contact arrière de l'hétérojonction 20.

La présente invention est décrite en référence aux figures qui permettent d'illustrer des modes de réalisation sans limiter l'enseignement général de l'invention décrite dans la présente description.

Parmi les cellules avant considérées se trouvent les cellules à base de matériaux III-V, associant les éléments de la colonne du gallium et de l'arsenic respectivement, des cellules à base de composés chalcogénures de type I-III-VI₂ associant les éléments des colonnes du cuivre, de l'indium, du soufre ou du sélénium, des cellules, également appelées chalcogénures, à base de composés II-VI du type CdTe, et enfin des cellules émergentes récentes à base de matériaux hybrides organique inorganique du type perovskite (PbNH₄I₃).

Ainsi, l'invention porte notamment sur des structures d'architecture Si/couches III-V/ (CIGS, CdTe ou Perovskite). La couche III-V d'interface joue avantageusement le rôle d'un facilitateur d'épitaxie pour ces couches qui est à même d'améliorer leurs propriétés en vue de l'application tandem.

### Matériau monocristallin

Typiquement, le matériau monocristallin 10 est la plaquette (« wafer » en anglais) de la cellule photovoltaïque arrière. On peut également parler de substrat monocristallin 10.

De préférence, le matériau monocristallin 10 comprend ou est constitué de silicium monocristallin. Avantageusement, le silicium monocristallin peut comprendre des zones dopées, et de préférence des zones différemment dopées.

Typiquement, l'épaisseur de la couche de matériau monocristallin 10 va de 50 à 300µm, et en général de 100 à 200µm.

Selon une variante, la face arrière 12 comprend des électrodes de contact interdigitées 40.

Par exemple, le matériau monocristallin 10 présente sur sa face arrière 12 au moins une couche de contacts arrière 60 sous forme de bandes conductrices, généralement séparées d'une distance de quelques centaines microns ou quelques millimètres. Typiquement, il s'agit les bandes conductrices de polarités opposées d'une largeur en général de l'ordre 0,5 à 5 mm. Les électrodes interdigitées peuvent être déposées avant ou après la réalisation du matériau multi-couches de l'invention. Elles sont en générale déposées après la croissance des couches épitaxiées.

Selon un mode de réalisation, la couche de contacts arrière 60 peut être déposée de façon continue puis ensuite structurée, par exemple par photolithographie et gravure (« etching »), avant d'être réintroduite dans une chambre d'épitaxie.

Avantageusement, la particularité du matériau monocristallin est de conserver un caractère monocristallin sur toute sa surface, en particulier sa surface avant, permettant une croissance épitaxiale de matériaux de la jonction avant de la cellule tandem, par exemple de type III-V, chalcogénure (CIGS, CdTe) ou perovskite.

De préférence, le matériau monocristallin 10 et des électrodes de contact interdigitées 40 sur la face arrière 12 forment une première cellule photovoltaïque, et de préférence forment une cellule silicium.

Selon une variante, la cellule arrière forme une cellule silicium à face arrière.

### Couche isolante

Avantageusement, la présente invention permet de disposer des meilleures performances des cellules photovoltaïques en associant le caractère monocristallin du matériau monocristallin de la jonction arrière 300 et de la jonction avant 200, tout étant indépendantes électriquement l'une de l'autre.

Par couche isolante on entend une couche isolante électriquement de sorte que la jonction avant 200 soit indépendante électriquement de la jonction arrière 300 et inversement.

Selon un mode de réalisation, la cellule photovoltaïque avant et la cellule photovoltaïque arrière présentent des connectiques électriques 500 indépendantes.

Avantageusement, la couche isolante 30 est monocristalline.

Avantageusement, la couche isolante 30 est épitaxiée

Comme connu de l'homme du métier, la surface avant 11 du matériau monocristallin 10 doit être de qualité suffisante pour permettre une croissance épitaxiale.

Selon une variante, la couche isolante 30 comprend ou est constitué de nitrure d'aluminium (AIN), et/ou de phosphure d'aluminium (AIP), et/ou de phosphure de gallium (GaP) et/ou d'un mélange de phosphure d'aluminium et de phosphure de gallium ((AI,Ga)P), et/ou d'un mélange de nitrure d'aluminium et de nitrure de gallium ((AI,Ga)N).

De préférence, la couche isolante (30) comprend ou est constitué de nitrure d'aluminium (AlN) et/ou de phosphure d'aluminium (AlP), et/ou l'un quelconque des alliage comprenant AlN ou AlP, ou des oxydes comme par exemple Gd₂O₃, Al₂O₃ et (Ba,Sr)TiO₃.

Selon un mode de réalisation, la couche isolante 30 n'est pas un oxyde monocristallin.

Selon un mode de réalisation, la couche isolante 30 est un oxyde monocristallin, par exemple la couche isolante 30 comprend ou est constituée d'oxyde d'aluminium.

Selon une variante, la couche isolante (30) comprend ou est constitué d'oxydes composés à base d'aluminium, de titane, de zircone, de gadolinium. Parmi ceux-ci, on peut citer tout particulièrement le Gd₂O₃, Al₂O₃ et (Ba,Sr)TiO₃.

Selon une variante, la couche isolante 30 est formée par dépôt chimique en phase vapeur (ou CVD pour l'anglais chemical vapor déposition), épitaxie par jets moléculaires (ou MBE pour Molecular Beam Epitaxy en anglais) ou dépôt chimique en phase vapeur assisté par plasma (ou PECVD, pour Plasma-Enhanced Chemical Vapor Deposition en anglais).

Typiquement, l'épaisseur de la couche isolante 30 va de 0,1 à 5 µm, et en général de 0,1 à 1µm.

### Hétérojonction

Selon une variante, la jonction avant 200 est une hétérojonction III-V.

Selon une variante, la jonction avant 200 est une hétérojonction chalcogénure (CIGS).

Selon une variante, la jonction avant 200 est une hétérojonction de type kestérites (CZTS) ou Tellure de cadmium (CdTe) ou autre semi-conducteur inorganique multinaire, par exemple de type phosphure, arséniure ou halogénure.

Selon un mode de réalisation, l'hétérojonction comprend ou est constituée verticalement de composés semi-conducteurs de type III-V ou CIGS (Cu,Ag)(In,Ga,Al),(S,Se)₂,), et de préférence d'une alternance horizontale de composés semi-conducteurs de type III-V, combiné ou non avec du CIGS.

« I-III-(VI)₂ » signifie une combinaison de matériaux issus des colonnes des éléments I et III et VI.

Il peut s'agir par exemple d'un composé du type (Ag,Cu)(In,,Al,Ga)(S,Se)₂).

De préférence, l'hétérojonction comprend une hétérojonction épitaxiée, par exemple de type III-V ou I-III-VI-II.

Avantageusement, l'hétérojonction avant présente une structuration de type monolithique.

Selon un mode de réalisation, le premier matériau 24 et le deuxième matériau 26 sont connectés en série de manière monolithique.

Selon une variante, l'hétérojonction comprend ou est constituée de différents types d'hétérojonctions.

Selon une variante, la jonction avant 200 comprend ou est constitué d'un premier matériau 24 et d'un deuxième matériau 26.

Selon une variante, le premier matériau 24 comprend ou est constitué d'un composé de type III-V ou de CIGS.

Selon une variante, le deuxième matériau 26 comprend ou est constitué d'un composé de type III-V, de Zn(S,O) ou de CdS.

De préférence, le deuxième matériau 26 comprend ou est constitué d'un composé de type III-V lorsque le premier matériau 24 est un composé III-V.

De préférence, le deuxième matériau 26 comprend ou est constitué de Zn(S,O) ou de CdS lorsque le premier matériau 24 est CIGS.

Selon une variante, au moins l'un parmi le premier matériau 24 et le deuxième matériau 26 comprend ou est constitué d'un composé de type III-V choisi parmi GalnP, GaAIAs et l'une quelconque de leurs combinaisons.

Selon une variante, au moins l'un parmi le premier matériau 24 et le deuxième matériau 26 est formée par PVD, CVD ou dépôt à partir de solutions (DS), par exemple par Electro-dépôt (ED, en anglais electrodeposition).

De préférence, lorsque le premier matériau 24 comprend ou est constitué de CIGS, le dépôt est réalisé par PVD, DS (ED) ou CVD.

De préférence, lorsque le premier matériau 24 et/ou le deuxième matériau 26 comprend ou est constitué d'un composé III-V, le dépôt est réalisé par CVD ou MBE.

Typiquement, l'épaisseur de la couche du premier matériau 24 va de 0,5 à 3 µm, et en général de 1 à 2µm.

Typiquement, l'épaisseur de la couche du deuxième matériau 26 va de 0,1 à 3 µm, et en général de 0,5 à 2µm.

Typiquement, la largeur d'une zone isolante (p2, p3), typiquement d'une bande isolante, entre deux zones semi-conductrices du premier matériau 24 et/ou du deuxième matériau 26 va de 5 à 40 µm, et en général de 15 à 25µm, et par exemple est de 20µm.

Typiquement, l'hétérojonction 20 est plutôt à contact arrière P (premier matériau 24) et avant N (deuxième matériau 26) mais l'inverse est aussi possible. Il s'agit d'un choix de connectique électrique uniquement dont on peut facilement s'affranchir.

### Couche de contact arrière 40

Typiquement, la jonction 200 avant comprend en face arrière une couche de contact arrière 40.

Selon une variante, la couche de contact arrière 40 comprend ou est constitué de nitrure de gallium (GaN) ou de phosphure de gallium (GaP) ou de l'une quelconque de leurs combinaisons avec d'autres éléments des colonnes III et V. Leurs propriétés électriques peuvent être par exemple fixées par dopage avec des éléments dopants de type n ou p suivant l'état de l'art.

Selon une variante, la couche de contact arrière 40 est formée par CVD, PECVD, ou MBE.

Typiquement, l'épaisseur de la couche de contact arrière 40 va de 0,1 à 3 µm, et en général de 0,5 à 1µm.

Typiquement, la largeur d'une zone conductrice de la couche de contact arrière 40 entre deux zones isolantes (p1), typiquement deux bandes isolantes, va de 3 à 10 mm, et en général de 5 à 8 mm.

Typiquement, la largeur d'une zone isolante (p1), typiquement d'une bande isolante, entre deux zones conductrices de la couche de contact arrière 40 va de 5 à 40 µm, et en général de 10 à 20µm.

### Couche de contact avant 50

Typiquement, la jonction 200 avant comprend en face avant une couche de contact avant 50.

Typiquement, le matériau multi-couches 1 selon l'invention comprend :
(iv) une couche transparente aux photons, conductrice 50 côté face avant 21 de l'hétérojonction 20.

Typiquement, la couche de contact avant 50 comprend ou est constitué d'un matériau transparent conducteur, et typiquement d'une couche d'oxyde conducteur transparent (en anglais transparent conducting oxide (TCO)).

De préférence, la couche de contact avant 50 comprend ou est constitué d'oxyde de zinc (ZnO) dopé, oxyde d'étain et d'indium (indium-tin oxide (ITO)), ou l'une quelconque de leur combinaisons.

De préférence, la couche de contact avant 50 est réalisée par PVD, DS (ED) ou CVD.

Typiquement, l'épaisseur de la couche de contact avant 50 va de 0,5 à 3 µm, et en général de 1 à 2µm.

Typiquement, la largeur d'une zone isolante (p3), typiquement d'une bande isolante, entre deux zones de la couche de contact avant 50 va de 5 à 40 µm, et en général de 15 à 25µm, et par exemple est de 20µm.

Avantageusement, l'hétérojonction est structurée par une alternance des couches de manière à ce que la couche du premier matériau 24 et la couche de contact arrière 50 soient en contact alternativement avec la couche de contact arrière 40. Ainsi, la conduction électrique a lieu entre les zones conductrices adjacentes, de manière latérale en alternant une conduction entre les couches de contacts avant et arrière formant une conduction en série de la cellule photovoltaïque avant.

La présente invention permet de réaliser une jonction avant avec une interconnexion de type monolithique, bien connue pour la mise en modules de cellules en couches minces du type CIGS CdTe et Silicium amorphe et de l'associer à une structure silicium pour combiner les avantages de ces deux types de cellules. La cellule photovoltaïque avant peut être considérée comme un minimodule photovoltaïque.

La présente invention permet de réaliser une structure à la fois empilée verticalement (cellule tandem verticale) et horizontalement (interzones conductrices (typiquement interbandes) et inter-cellules photovoltaïques avant de chaque étage de part et d'autre de la couche isolante 30).

La présente invention permet de réaliser une structure dont l'assemblage de couches avant 100 conduit à une cellule avant absorbant les photons de longueur d'onde inférieure à environ 800 nm et transparente aux photons de longueur d'onde supérieure afin de permettre leur absorption par la cellule arrière, typiquement en silicium. Cela se traduit en énergie par une cellule avant caractérisée par une énergie de bande interdite d'environ 1,6-1,8 eV.

Selon un mode de réalisation, la couche isolante 30 est transparente pour un fonctionnement optimal de la cellule photovoltaïque arrière. Par exemple, une couche isolante 30 doit être transparente pour les photons d'énergie inférieure à la bande interdite de la cellule avant soit 1,6-1,8 eV et jusqu'à l'énergie de bande interdite de la cellule arrière, typiquement au silicium, 1,12 eV, de façon à ce que celle-ci puisse convertir de façon efficace en électricité les photons entre ces deux limites.

### Matériau spécifique

Selon une variante, le matériau multicouche 1 comprend un empilement vertical d'une cellule silicium, la couche silicium formant la couche de matériau monocristallin 10, et d'une cellule avec une hétérojonction 20, de préférence de type III-V, chalcogénure (CIGS, CdTe) ou perovskite, avec une couche 40 de contact arrière constituée d'un matériau III-V, de préférence à base de GaN ou GaP.

Selon une variante, la combinaison de couches de matériaux monocristallins 10, les couches formant une hétérojonction 20, la couche isolante électriquement 30, et éventuellement la ou les couches intermédiaires entre ces couches forment une combinaison de couches monocristallines, et de préférence entièrement monocristallines.

Avantageusement, selon une variante, le premier matériau 24 et le deuxième matériau 26 sont épitaxiés de type III-V sur silicium (matériau monocristallin 10) avec une couche épitaxiée isolante 30 entre le silicium 10 et le premier matériau 24, et plus particulièrement entre le silicium 10 et la couche de contact arrière 40.

Avantageusement, selon une variante, le premier matériau 24 est épitaxié pour la formation d'une couche chalcogénure (CIGS, CdTe) ou perovskite sur silicium (matériau monocristallin 10) avec une couche épitaxiée isolante 30 entre le silicium 10 et le premier matériau 24, et plus particulièrement entre le silicium 10 et la couche de contact arrière 40. Le deuxième matériau 26 peut former une couche tampon et peut être déposé par une autre technique que l'épitaxie, comme connu de l'homme de l'art (notamment pour une couche Zn(O,S) ou CdS par exemple).

Avantageusement, selon une variante, le matériau multi-couches 1 forme en totalité ou en partie une cellule tandem à quatre fils ou quatre contacts électriques, associant une monocellule silicim à contact arrière et un minimodule photovoltaïque en face avant.

Selon une variante, le matériau multi-couches 1 comprend l'enchainement, en contact direct ou non, des couches suivantes :
Couche isolante 30 : (Alₓ,Ga₍₁₋ₓ₎)P, où x vaut de 0 à 1 ou (Alₓ,Ga₍₁₋ₓ₎)N, où x vaut de 0 à 1 ;
Couche de contact arrière 40 : GaN ou GaP ;
Couche de premier matériau 24 : III-V ((GaInP ou GaAlAs par exemple) ;
Couche de deuxième matériau 26 : III-V ((GaInP ou GaAlAs par exemple) ;
Couche de contact avant 50: ITO ou ZnO

Selon une variante le matériau multi-couches 1 comprend l'enchainement, en contact direct ou non, des couches suivantes :
Couche isolante 30 : (Alₓ,Ga₍₁₋ₓ₎)P, où x vaut de 0 à 1, (Alₓ,Ga₍₁₋ₓ₎)N, où x vaut de 0 à 1 ;
Couche de contact arrière 40 : GaN ou GaP ;
Couche de premier matériau 24 : CIGS ;
Couche de deuxième matériau 26 : Zn(O,S) ou CdS par exemple ;
Couche de contact avant 50: ITO ou ZnO

Selon une variante, le matériau multi-couches 1 comprend l'enchainement, en contact direct ou non, des couches suivantes : Si/AlN/GaN/ClGS/TCO

Selon une variante, le matériau multi-couches 1 comprend l'enchainement, en contact direct ou non, des couches suivantes : Si/AlP/GaP/ClGS/TCO

Selon une variante, le matériau CdTe ou ses alliages (par exemple avec soufre, selenium, zinc, magnésium), ou perovskites remplacent le CIGS dans les configurations précédentes. Les couches supérieures nécessaires pour compléter la cellule avant sont celles qui sont spécifiques à ces cellules selon l'état de l'art.

Selon une variante, le matériau multi-couches 1 comprend l'enchainement, en contact direct ou non, des couches suivantes : III-V/(Cd,Zn)(S,Se)/(Cd,Zn)Te/TCO

Avantageusement, ces matériaux permettent d'accorder les différences de paramètre de maille lorsque nécessaire.

Avantageusement, ces matériaux permettent d'accorder la correspondance optique et structurelle des matériaux lorsque nécessaire.

Avantageusement, ces matériaux permettent d'accorder la correspondance électronique des matériaux lorsque nécessaire.

De préférence, la couche isolante 30 est épitaxiée directement sur le matériau monocristallin 10, typiquement du silicium monocristallin.

De préférence, pour une cellule de type III-V : les couches GaInP ou GaAIAs sont épitaxiées sur la couche isolante de AIN ou AIP elle-même épitaxiée.

Les contacts électriques peuvent être typiquement réalisés une fois les couches semi-conductrices du matériau multicouches 1 terminées.

On forme ainsi une cellule photovoltaïque tandem avec une cellule photovoltaïque arrière à contact arrière et une cellule photovoltaïque avant à contact avant, les cellules photovoltaïques étant indépendantes électriquement.

On peut par exemple connecter électriquement par contacts électriques la face arrière de jonctions arrière 300 en série entre elles.

On peut par exemple connecter électriquement par contacts électriques la face avant de jonctions avant 200 en série entre elles.

On obtient ainsi deux réseaux en série l'un au-dessus de l'autre et isolé électriquement l'un de l'autre.

Typiquement, Les couches du matériau multi-couches 1 selon l'invention sont empilées verticalement et sont en contact directe les unes aux autres, éventuellement espacées d'une ou plusieurs couches intermédiaires.

### Procédé

L'invention concerne aussi un procédé de fabrication d'un matériau multi-couches 1 tel que défini selon l'invention.

Selon une variante le procédé comprend consécutivement :
(i) la préparation d'un matériau monocristallin 10 présentant une face avant 11 et une face arrière 12 ;
(ii) le dépôt ou la croissance d'une couche isolante électriquement 30 sur la face avant 11 du matériau monocristallin 10, ladite couche isolante 30 présentant une face avant 31 et une face arrière 32 ;
(iii) le dépôt ou la croissance sur la face avant 31 de la couche isolante 30 d'une couche 40, comprenant une face avant 41 et une face arrière 42, dite de contact arrière d'une hétérojonction 20, la face avant 41 étant en contact avec la face arrière 22 de l'hétérojonction 20 ;
(iv) le dépôt ou la croissance sur la face avant 41 de la couche de contact arrière 40 d'une couche d'un premier matériau 24 d'une hétérojonction 20 puis le dépôt ou la croissance d'une couche d'un deuxième matériau 26, l'hétérojonction 20 comprenant une face avant 21 et une face arrière 22 ;
(v) la structuration P1 de zones, dites premières zones isolantes p1, isolant des zones conductrices de la couche de contact arrière 40 la structuration P1 formant des contacts alternatifs côté face avant 31 de la couche isolante électriquement 30 avec la couche arrière 40 de l'hétérojonction 20 et la face arrière 22 de l'hétérojonction 20 ; la structuration P1 intervenant de préférence avant ou après le dépôt ou la croissance du premier matériau 24 et du deuxième matériau 26 ;
ladite couche isolante électriquement 30 étant disposée entre la face arrière 42 de la couche de contact arrière 40 de l'hétérojonction 20 et la face avant 11 du matériau monocristallin 10.

Selon une variante, le procédé comprend :
(vi) la structuration P2 de zones, dites deuxièmes zones isolantes p2, isolant des zones semi-conductrices de l'hétérojonction 20 ;
les premières p1 et deuxièmes p2 zones isolantes ne se superposant pas dans l'empilement vertical des couches du matériau multicouche 1.

Selon une variante, le procédé comprend :
(viii) le dépôt ou la croissance sur la face avant 21 de l'hétérojonction 20 d'une couche 50 conductrice transparente aux photons (du spectre solaire, typiquement 300nm-1200nm), et
(ix) la structuration P3 de zones, dites deuxièmes zones isolantes p3, isolant des zones conductrices de couche 50 conductrice ;
les premières p1, deuxièmes p2 et troisièmes p3 zones isolantes ne se superposant pas dans l'empilement vertical des couches du matériau multicouche 1.

Avantageusement, les couches 24 et 26 sont structurées à l'étape P2.

Avantageusement, les couches 24 et 26 sont structurées à l'étape P3.

Selon une variante, la structuration (P2) intervient de préférence avant le dépôt ou la croissance sur la face avant 21 de l'hétérojonction 20 d'une couche 50 conductrice transparente aux photons.

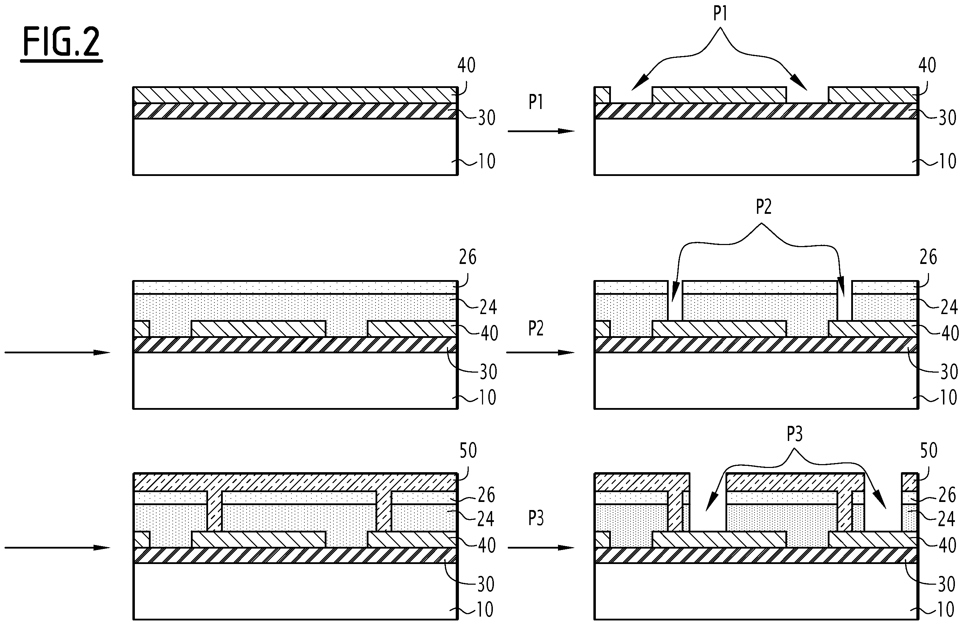

Selon un mode de réalisation, par exemple illustré à la figure 2, le procédé comprend la préparation d'une cellule tandem, ledit procédé comprenant la préparation d'une cellule photovoltaïque silicium monocristallin à contact arrière, un dépôt d'une couche isolante 30 par croissance épitaxiale sur la face avant du silicium monocristallin 10, un dépôt d'une couche de contact arrière 40 par croissance épitaxiale sur la face avant 31 de la couche isolante 30, une structuration P1 en sillons de la couche de contact arrière 40, un dépôt d'une couche d'un premier matériau 24 par croissance épitaxiale formant une première couche d'une hétérojonction 20, un dépôt d'une couche d'un deuxième matériau 26 (par croissance épitaxiale ou non comme par exemple dans le cas du CIGS et des perovskites) formant une deuxième couche de l'hétérojonction 20 sur la couche du premier matériau 24, une structuration P2 en sillons des couches du premier matériau 24 et du deuxième matériau 26, un dépôt d'une couche de contact avant 50 d'un matériau transparent conducteur, une structuration P3 en sillons de la couche de contact avant 50 et des couches du premier matériau 24 et du deuxième matériau 26, un dépôt d'une protection de la face avant de la cellule tandem, par exemple par une couche de verre.

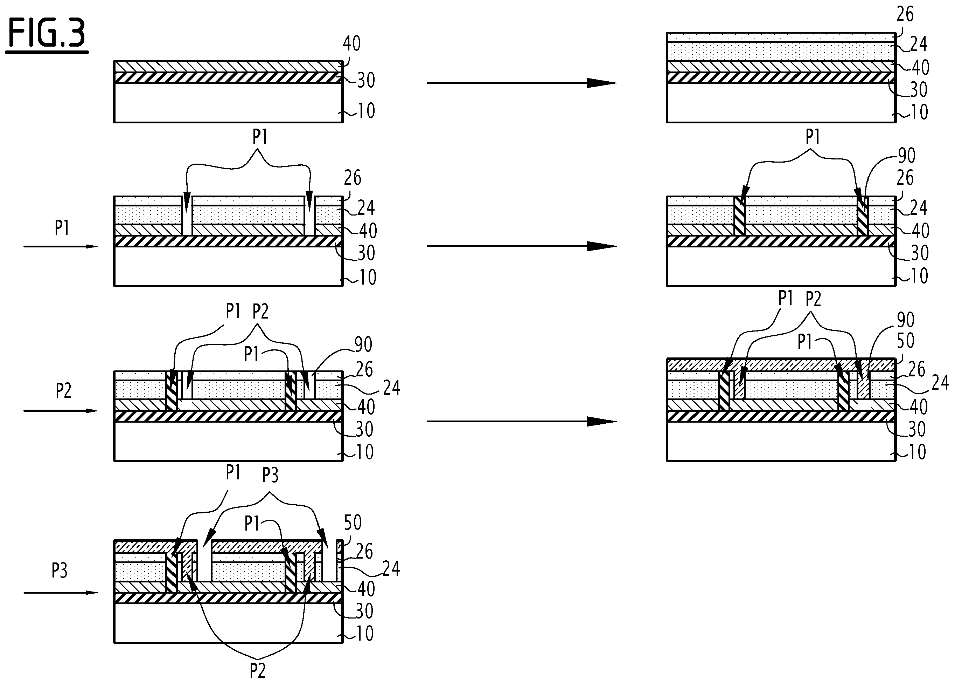

Selon un mode de réalisation, par exemple illustré à la figure 3, le procédé comprend la préparation d'une cellule tandem, ledit procédé comprenant la préparation d'une cellule photovoltaïque silicium monocristallin à contact arrière, un dépôt d'une couche isolante 30 par croissance épitaxiale sur la face avant du silicium monocristallin 10, un dépôt d'une couche de contact arrière 40 par croissance épitaxiale sur la face avant 31 de la couche isolante 30, un dépôt d'une couche d'un premier matériau 24 par croissance épitaxiale formant une première couche d'une hétérojonction 20, un dépôt d'une couche d'un deuxième matériau 26 (par croissance épitaxiale ou non comme dans le cas du CIGS et des perovskites) formant une deuxième couche de l'hétérojonction 20 sur la couche du premier matériau 24, une fois ces couches terminées, une structuration P1 en sillons des couches du premier matériau 24 et du deuxième matériau 26 et de la couche de contact arrière 40, une structuration P2 en sillons des couches du premier matériau 24 et du deuxième matériau 26, un dépôt d'une couche de contact avant 50 d'un matériau transparent conducteur, une structuration P3 en sillons de la couche de contact avant 50 et des couches du premier matériau 24 et du deuxième matériau 26, un dépôt d'une protection de la face avant de la cellule tandem, par exemple par une couche de verre. Les structurations en sillons P1 peuvent être suivies d'un remplissage d'un matériau isolant électrique 90, et de préférence transparent dans le spectre solaire (typiquement les longueurs d'ondes 300nm-1200nm), par exemple de type polymère.

Pour obtenir facilement la connexion monolithique, selon une variante, les structurations P1, P2, P3 doivent être positionnées successivement et répétitivement dans cet ordre de gauche à droite ou inversement.

Ainsi, on peut réaliser une couche épitaxiée isolante à la surface du silicium et de reprendre ensuite la croissance de couches III-V en les structurant en bandes latérales de façon à réaliser une connexion monolytique entre les bandes épitaxiées.

Avantageusement, la couche de contact arrière 40 de la jonction III-V, ou des autres jonctions considérées (CIGS, CdTe, Perovskite) présente une bonne conduction électrique dans le plan horizontal.

L'invention concerne aussi un matériau multi-couches 1 obtenu selon un procédé de fabrication tel que défini selon l'invention.

La présente invention permet la réalisation de cellules tandem Si III-V à très haut rendement, de préférence grâce à une configuration quatre fils par croissance épitaxiale d'une jonction III-V sur une cellule silicium à contacts arrières interdigités et la réalisation d'une connexion de type monolytique de la jonction III-V.

La présente invention peut être utilisée pour des cellules avant de type III-V, CIGS, CdTe, perovskite hybride ou autres matériaux multinaires inorganiques (chalcogénures, phosphures, arséniures, halogénures...)

La présente invention propose une nouvelle architecture permettant de combiner l'avantage des cellules épitaxiées avec celui offert par les configurations quatre fils, la configuration épitaxiée actuelle étant limitée au type 2 fils.

### Application

L'invention concerne aussi une cellule photovoltaïque caractérisée en ce qu'elle comprend ou est constituée d'un ou plusieurs matériaux multi-couches 1 tels que définis selon l'invention, ou obtenus par un procédé tel que défini selon l'invention, et de préférence formant une double jonction (dite aussi cellule tandem).

L'invention concerne aussi un dispositif mobile ou immobile comprenant un générateur d'électricité et caractérisé en ce que l'électricité est produite par la mise en oeuvre d'un ou plusieurs matériaux multi-couches 1 tels que définis selon l'invention ou obtenus par un procédé tel que défini selon l'invention.

L'invention concerne aussi une méthode de production d'électricité à partir de radiations électromagnétiques caractérisée en ce qu'un ou plusieurs matériaux multi-couches 1 tels que définis selon l'invention, ou obtenus par un procédé tel que défini selon l'invention, sont exposés à des radiations électromagnétiques, de préférence côté face avant 101 et en ce que l'on collecte un courant électrique, de particulier par des électrodes de contact interdigitées 60 côté face arrière 102.
Sur les figures :

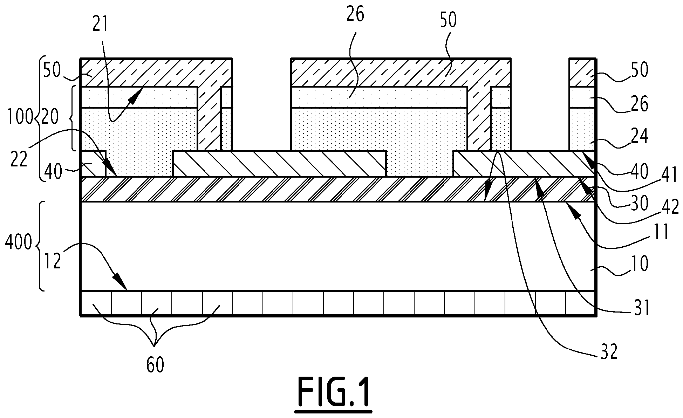

La figure 1 représente schématiquement une section d'un matériau multi-couches selon un mode de réalisation de la présente invention.
La figure 2 représente schématiquement un mode de réalisation d'un procédé de fabrication d'un matériau multi-couches selon la présente invention.
La figure 3 représente schématiquement un mode de réalisation d'un procédé de fabrication d'un matériau multi-couches selon la présente invention.

## Revendications

1. Matériau multi-couches (1) comprenant :
(i) un assemblage de couches, dites « couches avant » (100), apte à former une cellule photovoltaïque avant et
(ii) un assemblage de couches, dites « couches arrière » (400), apte à former une cellule photovoltaïque arrière,
dans lequel l'assemblage de couches avant (100) et l'assemblage de couches arrière (400) sont isolés électriquement par une couche isolante (30) de matériau épitaxié.

2. Matériau multi-couches (1) selon la revendication 1, **caractérisé en ce que** l'assemblage de couches avant (100) comprend au moins une combinaison de couches formant une hétérojonction (20) comprenant un premier matériau (24) et un deuxième matériau (26), une couche (40) de contact arrière de l'hétérojonction (20), et une couche (50) de contact avant.

3. Matériau multi-couches (1) selon la revendication 1, **caractérisé en ce que** l'assemblage de couches arrière (400) comprend au moins matériau monocristallin (10), typiquement du silicium monocristallin, et de préférence comprend des électrodes de contact interdigitées (60).

4. Matériau multi-couches (1) comprenant :
(i) une couche d'au moins un matériau monocristallin (10) présentant une face avant (11) et une face arrière (12);
(ii) une combinaison de couches formant une hétérojonction (20) comprenant un premier matériau (24) et un deuxième matériau (26), l'hétérojonction (20) comprenant une face avant (21) et une face arrière (22);
(iii) une couche (40), comprenant une face avant (41) et une face arrière (42), dite de contact arrière de l'hétérojonction (20), la face avant (41) étant en contact avec la face arrière (22) de l'hétérojonction (20),
(iii) une couche isolante électriquement (30) de matériau épitaxié présentant une face avant et une face arrière, ladite couche isolante électriquement (30) étant disposée entre la face arrière (42) de la couche arrière (40) de l'hétérojonction (20) et la face avant (11) du matériau monocristallin (10) ;
ladite couche isolante électriquement (30) étant en contact alternatif côté face avant (31) avec la couche de contact arrière (40) de l'hétérojonction (20) et la face arrière (22) de l'hétérojonction (20) ou d'un matériau isolant (90).

5. Matériau multi-couches (1) selon l'une quelconque des revendications 1 à 4, **caractérisé en ce que** la couche isolante (30) est épitaxiée.

6. Matériau multi-couches (1) selon l'une quelconque des revendications 1 à 5, **caractérisé en ce que** la couche isolante (30) comprend ou est constitué de nitrure d'aluminium (AlN) et/ou de phosphure d'aluminium (AlP), et/ou l'un quelconque des alliage comprenant AlN ou AlP, ou des oxydes comme par exemple Gd₂O₃, Al₂P₃ et (Ba,Sr)TiO₃.

7. Matériau multi-couches (1) selon l'une quelconque des revendications 1 à 6, **caractérisé en ce que** l'assemblage de couches avant (100) comprend au moins une combinaison de couches formant une hétérojonction (20) comprenant un premier matériau (24) et un deuxième matériau (26) et **en ce que** l'hétérojonction comprend ou est constituée verticalement de composés semi-conducteurs de type III-V ou CIGS (Cu,Ag)(In,Ga,Al),(S,Se)₂,), et de préférence d'une alternance horizontale de composés semi-conducteurs de type III-V, combiné ou non avec du CIGS.

8. Matériau multi-couches (1) selon l'une quelconque des revendications 1 à 7, **caractérisé en ce que** l'assemblage de couches avant (100) comprend au moins une combinaison de couches formant une hétérojonction (20) comprenant un premier matériau (24) et un deuxième matériau (26) et **en ce que** le premier matériau (24) et le deuxième matériau (26) sont connectés en série de manière monolithique.

9. Matériau multi-couches (1) selon l'une quelconque des revendications 1 à 8, **caractérisé en ce que** le matériau multi-couches (1) comprend une couche d'au moins un matériau monocristallin (10) présentant une face avant (11) et une face arrière (12) et **en ce que** la face arrière (12) comprend des électrodes de contact interdigitées (40).

10. Matériau multi-couches (1) selon l'une quelconque des revendications 1 à 9, **caractérisé en ce que** l'assemblage de couches avant (100) comprend au moins une combinaison de couches formant une hétérojonction (20) comprenant un premier matériau (24) et un deuxième matériau (26) et **en ce que** le matériau multi-couches (1) comprend une couche (50), comprenant une face avant (51) et une face arrière (52), dite de contact avant de l'hétérojonction (20), la face arrière (52) étant en contact avec la face avant (21) de l'hétérojonction (20), la couche (50) de contact avant comprenant ou étant constituée d'un matériau transparent conducteur, et **caractérisé en ce que** la face arrière (22) de l'hétérojonction (20) et la couche (50) de contact avant sont alternativement en contact avec la couche (40) de contact arrière.

11. Matériau multi-couches (1) selon l'une quelconque des revendications 1 à 10, **caractérisé en ce que** l'assemblage de couches avant (100) comprend au moins une combinaison de couches formant une hétérojonction (20) comprenant un premier matériau (24) et un deuxième matériau (26) et **en ce que** le matériau multicouche (1) comprend un empilement vertical d'une cellule silicium, la couche silicium formant la couche de matériau monocristallin (10), et d'une cellule avec une hétérojonction (20), de préférence de type III-V, CIGS, CdTe, Perovskite, avec une couche (40) de contact arrière constituée d'un matériau III-V, de préférence à base de GaN ou GaP.

12. Matériau multi-couches (1) selon l'une quelconque des revendications 1 à 11, **caractérisé en ce que** l'assemblage de couches avant (100) comprend au moins une combinaison de couches formant une hétérojonction (20) comprenant un premier matériau (24) et un deuxième matériau (26) et **en ce que** la combinaison de couche(s) de matériau(x) monocristallin(s) (10), les couches formant une hétérojonction (20), la couche isolante électriquement (30), et éventuellement la ou les couches intermédiaires entre ces couches forment une combinaison de couches monocristallines, et de préférence entièrement monocristallines.

13. Matériau multi-couches (1) selon l'une quelconque des revendications 1 à 12, **caractérisé en ce que** l'assemblage de couches avant (100) comprend au moins une combinaison de couches formant une hétérojonction (20) comprenant un premier matériau (24) et un deuxième matériau (26) et **en ce que** le matériau comprend :
(iv) une couche transparente aux photons, conductrice (50) côté face avant (21) de l'hétérojonction (20).

14. Procédé de fabrication d'un matériau multi-couches (1) selon l'une quelconque des revendications 1 à 13.

15. Procédé selon la revendication 14, **caractérisé en ce que** le procédé comprend consécutivement :
(i) la préparation d'un matériau monocristallin (10) présentant une face avant (11) et une face arrière (12) ;
(ii) le dépôt ou la croissance d'une couche isolante électriquement (30) sur la face avant (11) du matériau monocristallin (10), ladite couche isolante (30) présentant une face avant (31) et une face arrière (32) ;
(iii) le dépôt ou la croissance sur la face avant (31) de la couche isolante (30) d'une couche (40), comprenant une face avant (41) et une face arrière (42), dite de contact arrière d'une hétérojonction (20), la face avant (41) étant en contact avec la face arrière (22) de l'hétérojonction (20) ;
(iv) le dépôt ou la croissance sur la face avant (41) de la couche de contact arrière (40) d'une couche d'un premier matériau (24) d'une hétérojonction (20) puis le dépôt ou la croissance d'une couche d'un deuxième matériau (26), l'hétérojonction (20) comprenant une face avant (21) et une face arrière (22) ;
(v) la structuration (P1) de zones, dites premières zones isolantes (p1), isolant des zones conductrices de la couche de contact arrière (40) la structuration (P1) formant des contacts alternatifs côté face avant (31) de la couche isolante électriquement (30) avec la couche arrière (40) de l'hétérojonction (20) et la face arrière (22) de l'hétérojonction (20) ; la structuration (P1) intervenant de préférence avant ou après le dépôt ou la croissance du premier matériau (24) et du deuxième matériau (26) ;
ladite couche isolante électriquement (30) étant disposée entre la face arrière (42) de la couche de contact arrière (40) de l'hétérojonction (20) et la face avant (11) du matériau monocristallin (10).

16. Procédé selon la revendication 14 ou 15, **caractérisé en ce que** le procédé comprend :
(vi) la structuration (P2) de zones, dites deuxièmes zones isolantes (p2), isolant des zones semi-conductrices de l'hétérojonction (20) ;
les premières (p1) et deuxièmes (p2) zones isolantes ne se superposant pas dans l'empilement vertical des couches du matériau multicouche (1).

17. Procédé selon l'une quelconque des revendications 14 à 16, **caractérisé en ce que** le procédé comprend :
(viii) le dépôt ou la croissance sur la face avant (21) de l'hétérojonction (20) d'une couche (50) conductrice transparente aux photons, et
(ix) la structuration (P3) de zones, dites deuxièmes zones isolantes (p3), isolant des zones conductrices de couche (50) conductrice ;
les premières (p1), deuxièmes (p2) et troisièmes (p3) zones isolantes ne se superposant pas dans l'empilement vertical des couches du matériau multicouche (1).

18. Cellule photovoltaïque **caractérisée en ce qu'**elle comprend ou est constituée d'un ou plusieurs matériaux multi-couches (1) tels que définis selon l'une quelconque des revendications 1 à 13, ou obtenus par un procédé tel que défini selon l'une quelconque des revendications 14 à 17, et de préférence formant une double jonction (dite aussi cellule tandem).

19. Dispositif mobile ou immobile comprenant un générateur d'électricité et **caractérisé en ce que** l'électricité est produite par la mise en oeuvre d'un ou plusieurs matériaux multi-couches (1) tels que définis selon l'une quelconque des revendications 1 à 13, ou obtenus par un procédé tel que défini selon l'une quelconque des revendications 14 à 17.

20. Méthode de production d'électricité à partir de radiations électromagnétiques **caractérisée en ce qu'**un ou plusieurs matériaux multi-couches (1) tels que définis selon l'une quelconque des revendications 1 à 13, ou obtenus par un procédé tel que défini selon l'une quelconque des revendications 14 à 17, sont exposés à des radiations électromagnétiques, de préférence côté face avant (101) et **en ce que** l'on collecte un courant électrique, de particulier par des électrodes de contact interdigitées (60) côté face arrière (102).
